# EUROPÄISCHE PATENTSCHRIFT

(11) **EP 3 265 509 B1**
(45) Veröffentlichungstag und Bekanntmachung des Hinweises auf die Patenterteilung: **19.06.2019**
(21) Anmeldenummer: 16710089.0
(22) Anmeldetag: 02.03.2016
(51) Int. Cl.: C08K 3/34, C08L 23/10, H01L 31/048

(54) **RÜCKSEITENFOLIE FÜR SOLARMODULE**
BACK SHEET FOR SOLAR CELL
FEUILLE DE FOND POUR CELLULES SOLAIRES

(30) Priorität: 03.03.2015 DE 102015103045
(43) Veröffentlichungstag der Anmeldung: 10.01.2018
(73) Patentinhaber: Bischof + Klein SE & Co. KG, 49525 Lengerich (DE)
(72) Erfinder: HÜLSMANN, Philip, 48147 Münster (DE); LEHRTER, Peter, 49477 Ibbenbüren (DE)
(74) Vertreter: Deters, Frank
(86) Internationale Anmeldenummer: PCT/EP2016/000362
(87) Internationale Veröffentlichungsnummer: WO 2016/138990

(56) Entgegenhaltungen:
- EP-B1- 2 390 093
- JP-A- 2014 091 218
- US-A1- 2014 137 935

## Beschreibung

Die Erfindung betrifft eine Rückseitenfolie für Solarmodule nach dem Oberbegriff des Anspruchs 1. Solarmodule stellen plattenförmige, jeweils einzeln oder in Gruppenanordnung montierbare Einheiten dar, in denen elektrisch miteinander verschaltete Solarzellen in einer mittleren Ebene angeordnet und dabei allseitig in einem Einkapselungsmaterial z. B. Ethylen-Vinylacetat-Copolymer (EVA) eingebettet sind. Die Vorderseite eines solchen Solarmoduls ist beispielsweise durch eine Glasscheibe als Frontabdeckung gebildet, die die EVA-Einbettung der Solarzellen vorderseitig (oberseitig) abdeckt und eine gute Lichtdurchlässigkeit, eine Witterungsbeständigkeit, Kratzfestigkeit in Bezug auf Umweltbeanspruchungen und Reinigungen und auch eine gute elektrische Isolation der Solarzellen zur vorderseitigen (oberseitigen) Umwelt hin und eine gute mechanische Stabilität bietet. Für eine rückseitige Abdeckung der Solarmodule wird generell eine Rückseitenfolie eingesetzt, die zwar nicht die Anforderungen der Vorderseite in Bezug auf Lichtdurchlässigkeit, wohl aber hohe Anforderungen an Witterungsbeständigkeit, elektrischer Durchschlagfestigkeit und Kompatibilität zur EVA-Einbettung bieten muss.

Insbesondere muss sich die Rückseitenfolie mit der EVA-Einbettung der Solarzellen im Paket zu einer festen und gekapselten Einheit in einem Laminations-Prozess verbinden lassen, bei dem die zunächst lageweise lose aufeinanderliegenden Materialien bei einer Temperatur von 140°C bis 160°C miteinander verbunden werden.

Dabei wird das EVA weit über seine Erweichungstemperatur erhitzt, so dass es die Solarzellen umschließt und an die Frontabdeckung wie auch an die Rückseitenfolie anbindet. Weiterhin wird das EVA aufgrund von chemischen Zusätzen oder durch Bestrahlung zu einer transparenten Masse und zu guter Witterungsbeständigkeit vernetzt. Die Rückseitenfolie ist bei diesem Vorgang als "Außenschale" beteiligt - mit dem Erfordernis einer entsprechenden Temperaturfestigkeit unter Ausschluss von Schrumpfungsvorgängen bei vorgedehnter Rückseitenfolie.

Im Sinne hoher Temperaturfestigkeit werden herkömmlich Rückseitenfolien auf Polyesterbasis verwandt, die allerdings eine schlechte Kompatibilität zum EVA aufweisen und mit haftenden Beschichtungen zu versehen sind. Auch die begrenzte langzeitige Hydrolysefestigkeit dieses Materials mit einer Neigung zur Wasseranlagerung und Versprödung ist nachteilig. Ein vielschichtiger Aufbau einer solchen Rückseitenfolie mit Zwischen- und/oder Deckschichten sowie ein relativ hoher Schrumpf bei der Modulfertigung markieren deutliche Nachteile des Polyestermaterials.

Aus der EP 2 390 093 B1 ist demgegenüber eine Rückseitenfolie auf der Basis von Polyethylen bekannt, wobei ein Material aus Polyethylen-Homopolymeren und -Copolymeren direkt - ohne Klebeschichten - durch Coextrusion zusammengefügt ist. Dem Polyethylen-Material kommt eine gute Kompatibilität zu EVA innerhalb des Solarmodul-Aufbaus zugute. Problematisch ist jedoch die Temperaturfestigkeit des Polyethylen-Materials, die durch ausgewählte Materialkomponenten und insbesondere auch durch Vernetzung des Materials angehoben werden soll. Abgesehen von dem Vernetzungsaufwand bleibt allerdings die begrenzte Temperaturfestigkeit nicht nur beim EVA-Einbettungsvorgang, sondern auch langzeitig kritisch, wenn etwa ein Solarmodul über Jahrzehnte im Außenbereich eingesetzt wird.

Aus der JP 2014 091218 A ist eine Rückseitenfolie nach dem Oberbegriff des Anspruchs 1 zu entnehmen, die eine bevorzugte Stärke zwischen 20 und 300 µm aufweist und die beispielsweise als Flachfolie im Gießverfahren herzustellen ist. Ein solches Verfahren ist insbesondere mit zunehmender Zahl der Folienschichten und mit einer höher vorgegebenen Gesamtstärke nur aufwendig durchführbar und mit Herstellungskosten belastet, die für den Mengenbedarf an Rückseitenfolien und im Hinblick auf den Kostendruck des Markts unvorteilhaft sind.

Aus der US 2014/137935 A1 ist eine Rückseitenfolie mit mehreren Polyolefin-Schichten in miteinander laminierter Form zu entnehmen, bei denen Polypropylen-Schichten oder Polypropylen-Copolymerschichten einzusetzen sind, die auch einen hohen Füllgrad von anorganischem oder organischem Füller enthalten sollen und in zumindest einer Richtung gestreckt sein sollen. Das Herstellungsverfahren einer solchen Rückseitenfolie ist aufwendig und dementsprechend kostenbelastet.

Aufgabe der Erfindung ist es, eine Rückseitenfolie für Solarmodule zu finden, die witterungsbeständig und thermisch robust sowie preisgünstig zu erstellen ist und die insbesondere beständige und preisgünstige Solarmodule mit jahrzehntelanger Funktionsfähigkeit zu erstellen erlaubt.

Gemäß der Erfindung wird diese Aufgabe von einer Rückseitenfolie nach dem Oberbegriff des Anspruchs 1 ausgehend mit den kennzeichnenden Merkmalen des Anspruchs 1 gelöst. Weiterhin wird die Aufgabe mit einem Verfahren nach dem Anspruch 9 gelöst.

Die Rückseitenfolie nach Anspruch 1 sieht einen Verbund von Schichten aus Polypropylen oder aus einem Polyolefingemisch mit wesentlichem Polypropylen-Anteil vor, woraus sich für den nutzbaren Temperaturbereich eine wesentliche Erhöhung gegenüber Polyethylen-basierten Kunststoffmischungen ergibt. Damit kann vor allem auf eine umständliche und kostentreibende Vernetzung des Materials verzichtet werden. Weitere Ausdehnungen des verfügbaren Temperaturbereichs lassen sich durch anorganische stabilisierende Füllstoffe erzielen, die auch die mechanischen Eigenschaften der Folie verbessern können und dabei auch einem Schrumpfverhalten entgegenwirken. Dem Polypropylen kommt dabei auch die Vielseitigkeit, die Anwendungskenntnisse der Fachwelt bei umfänglichen und weit verzweigten Einsatzgebieten und die Langzeiterfahrungen mit dem Massenwerkstoff zugute. Dabei versteht es sich, dass bekannte Anfälligkeiten des Polypropylens gegenüber Oxidation, Lichtempfindlichkeit oder Brennbarkeit verlässlich und erprobt durch übliche Antioxidantien, Lichtschutzmittel, UV-Absorber und Flammhemmer zu behandeln sind.

Eine solche Rückseitenfolie lässt sich im Wege der Coextrusion mit untereinander direkt verbundenen Schichten preisgünstig herstellen. Insbesondere erspart die Coextrusion eine Verbindung der Schichten über Zwischenschichten mit Klebematerialien, die zusätzliche Arbeitsgänge erfordern.

Im Sinne einer Gleichmäßigkeit der Folienstärke und auch der Schichtungen sind die Schichten bei der Coextrusion mit begrenzter Schichtstärke auszuführen. Dies gilt insbesondere im Hinblick auf eine Gesamtstärke der Rückseitenfolie von über 300 µm (0,3 mm), die sich regelmäßig schon aus der geforderten elektrischen Durchschlagsfestigkeit der Rückseitenfolie für Spannungen bis z.B. 20 KV ergibt, die aber auch den Anforderungen eines Solarmoduls in Bezug auf mechanische Beanspruchungen Rechnung trägt. Folglich ist die Rückseitenfolie aus einer Mehrzahl coextrudierter Schichten aufgebaut. Dabei ist allerdings die dem Polypropylen allgemein zuzurechnende Härte und Steifigkeit, erforderlichenfalls auch die durch Modifikation bekanntermaßen leicht einzustellende Schlagzähigkeit von Vorteil.

Bei einem mehrschichtigen Aufbau der Rückseitenfolie ist bereits in herkömmlicher Weise eine Vorderschicht, den Solarzellen zugewandt und direkt mit der EVA-Einbettung verbunden, auf eine Reflektion von Licht ausgelegt, welches die Solarzellen seitlich oder als Streulicht passiert und zur Restnutzung zurückgeworfen werden soll. In dieser Hinsicht wird eine erste Schicht mit einer Stärke von weniger als 100 µm, vorzugsweise nur etwa 50 µm, mit Pigmenten wie etwa Titandioxid und/oder mit reflektierenden Partikeln bis zu einem Gewichtsanteil von etwa 20% gefüllt, so dass das Licht durch die glasklar vernetzte EVA-Einbettung wieder zu den Solarzellen bzw. zur Frontabdeckung im Sinne einer Innenreflektion zurückgeworfen wird. Zur besseren Haftung der Vorderschicht an die Ethylen-Vinylacetat-Copolymer - Einbettung der Solarzellen kann dem Polypropylen der Vorderschicht ein Anteil bis zu 60 % eines Polyethylens oder eines Polyethylen-Copolymers zugegeben werden.

Die hinter der Vorderschicht verbleibende Gesamtstärke der Rückseitenfolie wird vorteilhaft weiterhin in Schichten unterteilt. Beispielsweise kann eine außenliegende Schicht, wie vielfach üblich, aus rein optischen Gesichtspunkten und auch zur Reflektion von hinten einfallender Wärmestrahlung weiß bzw. reflektierend eingefärbt sein. Dementsprechend kann die der Vorderschicht gegenüberliegende hintere Außenschicht sogar mit dem gleichen Material wie die Vorderschicht vorgegeben werden und aus dem gleichen Extruder zur Coextrusion beschickt werden.

Zwischenliegende Schichten werden insbesondere mit einem anorganischen stabilisierenden Füllstoff mit einem Gewichtsanteil bis zu 40%, bezogen auf das Gesamtgewicht der Rückseitenfolie versehen, um damit höhere mechanische Festigkeiten wie auch eine erhöhte Temperaturfestigkeit zu erzielen und Schrumpfneigungen beim Laminierungsvorgang des EVA wie auch beim Langzeiteinsatz entgegenzuwirken.

Als Füllstoff kommt insbesondere, neben sonstigen mineralischen säurebeständigen Materialien, Talkum in Betracht, das sich in Bezug auf Polypropylen erprobtermaßen - auch in Bezug auf eine langzeitige Witterungsfestigkeit des Materials - bewährt hat. Eine Säurefestigkeit des Füllstoffes ist im Hinblick auf mögliche Langzeitentwicklungen des EVA-Materials zu einem sauren Status hin von Interesse. Dabei kann der Füllstoff in den einzelnen Schichten jeweils einen Gewichtsanteil der Schicht von zumindest 5% aufweisen, um eine Schicht oder einzelne Schichten besonders bei der Vernetzung des EVA-Materials im Zuge der Herstellung wie auch im ggf. jahrzehntelangen Einsatz langzeitig entgegen Schrumpfungstendenzen des Materials zu stabilisieren oder insgesamt zu versteifen.

Ein unter dem Gesichtspunkt der Fertigungskosten interessantes und in der Praxis besonders einfach zu installierendes Verfahren zur Herstellung einer Rückseitenfolie besteht in der Herstellung eines mehrschichtigen Blasfolienschlauchs mit Coextrusion mehrerer Schichten aus oder mit einem Polypropylen, wobei der Blasfolienschlauch nach der Extrusion und Blasformung über Walzen flach umgelenkt oder zwischen Walzen flach zusammengedrückt wird, so dass der Blasfolienschlauch durch innenseitiges Blocken an den aufeinanderliegenden Innenschichten zu einem flachen Folienband geformt wird.

Damit entsteht eine mehrschichtige Flachfolie mit einer gradzahligen Schichtung und einem (spiegel)symmetrischen Schichtaufbau. Wird beispielsweise die Außenschicht der Blasfolie durch ein mit Pigmenten oder reflektierenden Partikeln gefülltem Polypropylen gebildet, dann bildet diese Schicht sowohl eine Vorderschicht der Rückseitenfolie wie auch eine gegenüberliegende Hinterschicht mit entsprechender Färbung und entsprechenden Reflektionseigenschaften. Eine Zwischenschicht der Blasfolie, die nach dem Blocken in der Rückseitenfolie dann symmetrisch in der Schichtung wiederkehrt, kann insbesondere geeigneten Füllstoffe aufnehmen. Eine Innenschicht der Blasfolie, die nach dem Blocken in der Rückseitenfolie innenseitig verdoppelt auftritt, ist zweckmäßig auf das Blocken hin auszulegen. Füller, wie etwa Talkum, die sonst auch als Antiblockmittel eingesetzt werden, sind zweckmäßig reduziert vorzusehen oder fortzulassen. Für einen wirkungsvollen Blockvorgang kann sogar die Innenschicht der Blasfolie mit einer Beimischung von bis zu 60% Polyethylen neben dem Polypropylen versehen sein, um einerseits mit dem niedrigen Schmelzpunkt des Polyethylens eine wirkungsvolle Blockverbindung der zusammenzuführenden Seiten der Innenschicht herzustellen, andererseits durch das Polypropylen noch eine Stabilität der Schicht zu gewährleisten. Vorzugsweise ist die Innenschicht dabei im Verhältnis zu den übrigen Schichten dünner, jeweils weniger als 50 µm dick, auszuführen.

Beide Verfahren zur Herstellung der Rückseitenfolie, nämlich sowohl die Coextrusion einer flachen Gießfolie wie auch die Coextrusion einer Blasfolie mit anschließendem Blocken lassen sich großtechnisch auf eine gut beherrschbare und auch kostengünstige Weise durchführen und eröffnen die Möglichkeit, eine Folie auf Polypropylenbasis bereitzustellen, die insbesondere thermisch bei einem Laminiervorgang der Solarmodule stabil und ohne Schrumpfung bleibt und die auch im langzeitigen, oft über Jahrzehnte anzusetzenden Gebrauch des Solarmoduls Witterungsbeständigkeit und mechanische Haltbarkeit sowie festen Zusammenhalt mit der EVA-Einbettung der Solarzellen sichert.

Die Rückseitenfolie kann zu modularen Einzelstücken konfektioniert werden, die auf einzelne Solarmodule zugeschnitten werden und dann mit einem Satz von Solarzellen, dessen beidseitiger Belegung mit EVA und einer Frontabdeckung einen Laminator durchlaufen.

## Patentansprüche

1. Rückseitenfolie für Solarmodule, die in transparentem und bei einer Temperatur von mehr als 140° vernetztem EVA (Ethylen-Vinylacetat-Copolymer) bei rückseitig an dem EVA anliegender und dabei anbindender Rückseitenfolie eingebettet werden, wobei die Rückseitenfolie in einem mehrschichtigen Aufbau mit coextrudierten direkt miteinander verbundenen Schichten von Polyolefin besteht, von denen eine Vorderschicht mit einer Schichtdicke von weniger als 100 µm mit Pigmenten oder reflektierenden Partikeln in einem Gewichtsanteil bis zu 20% gefüllt ist, wobei die Schichten insgesamt oder mit einem Mischungsanteil aus unvernetztem Polypropylen bestehen und wobei die hinter der Vorderschicht liegenden Schichten zumindest zum Teil mit einem anorganischen stabilisierenden Füllstoff mit einem Gewichtsanteil von bis zu 40% bezogen auf das Gewicht der Rückseitenfolie gefüllt sind, **dadurch gekennzeichnet, dass** die Rückseitenfolie aus einem mehrschichtigen Blasfolienschlauch besteht, der vor dem Erhärten durch Flachformen und Blocken symmetrisch gedoppelt ist und eine Gesamtstärke von über 300 µm aufweist.

2. Rückseitenfolie nach Anspruch 1, **dadurch gekennzeichnet, dass** der Füllstoff im Wesentlichen aus Talkum oder sonstigen mineralischen säurebeständigen Materialien besteht.

3. Rückseitenfolie nach Anspruch 2, **dadurch gekennzeichnet, dass** der Füllstoff in den hinter der Vorderschicht liegenden Schichten einen Gewichtsanteil der Schicht von zumindest 5% aufweist.

4. Rückseitenfolie nach Anspruch 1, 2 oder 3, **dadurch gekennzeichnet, dass** die Schichten insgesamt gradzahlig und spiegelbildlich angeordnet sind.

5. Rückseitenfolie nach Anspruch 4, **dadurch gekennzeichnet, dass** die beiden benachbarten innersten Schichten eine Beimischung von 30 bis 60% Polyethylen enthalten.

6. Rückseitenfolie nach Anspruch 5, **dadurch gekennzeichnet, dass** die beiden innersten Schichten jeweils weniger als 80 µm dick sind.

7. Rückseitenfolie nach Anspruch 5 oder 6, **dadurch gekennzeichnet, dass** die beiden innersten Schichten kein Talkum enthalten.

8. Rückseitenfolie nach einem der Ansprüche 1bis 7, **dadurch gekennzeichnet, dass** die Vorderschicht einen Anteil von bis zu 30 % Polyethylen enthält.

9. Verfahren zur Herstellung einer Rückseitenfolie nach einem der Ansprüche 1 bis 8, **dadurch gekennzeichnet, dass** durch Coextrusion eines Folienschlauchs mit mehreren Schichten aus einer Ringdüse, nachfolgendes Blasformen und Blocken des flachgelegten Folienschlauches vor dem Erhärten eine Flachfolie mit mehreren Schichten in gradzahliger und spiegelbildlicher Schichtanordnung erzeugt wird.

10. Verfahren nach Anspruch 9, **dadurch gekennzeichnet, dass** bei der Coextrusion innerhalb der äußeren Schicht zumindest eine weitere Schicht aus Polypropylen mit einem anorganischen Füllstoff in einem Gewichtsanteil von zumindest 5% extrudiert wird.

11. Verfahren zur Herstellung einer Rückseitenfolie nach Anspruch 9 oder 10, **dadurch gekennzeichnet, dass** bei der Coextrusion eine innerste Schicht aus einem Gemisch von Polypropylen und Polyethylen extrudiert wird.

## Claims

1. Back sheet for solar modules which are embedded in transparent EVA (ethylene-vinyl acetate copolymer) crosslinked at a temperature of more than 140° at a back sheet abutting and thereby being connected to the rear side of the EVA, the back sheet consisting of polyolefin in a multilayer design having coextruded directly interconnected layers, a front layer of said layers having a layer thickness of less than 100 µm being filled with pigments or reflective particles in a weight fraction of up to 20%, the layers consisting entirely of or having a mixing proportion of non-crosslinked polypropylene, and the layers lying behind the front layer being filled at least in part with an inorganic stabilising filler having a weight fraction of up to 40% based on the weight of the back sheet, **characterised in that** the back sheet consists of a multilayer blown film tube which is symmetrically doubled before hardening by means of flat forming and blocking and has a total thickness of over 300 µm.

2. Back sheet according to claim 1, **characterised in that** the filler consists substantially of talc or other mineral acid-resistant materials.

3. Back sheet according to claim 2, **characterised in that** the filler in the layers lying behind the front layer has a weight fraction of the layer of at least 5%.

4. Back sheet according to claim 1, 2 or 3, **characterised in that** the layers are arranged in even numbers and in mirror symmetry.

5. Back sheet according to claim 4, **characterised in that** the two adjacent innermost layers contain an admixture of from 30 to 60% polyethylene.

6. Back sheet according to claim 5, **characterised in that** the two innermost layers are each less than 80 µm thick.

7. Back sheet according to either claim 5 or claim 6, **characterised in that** the two innermost layers do not contain talc.

8. Back sheet according to any of claims 1 to 7, **characterised in that** the front layer contains a fraction of up to 30% polyethylene.

9. Method for producing a back sheet according to any of claims 1 to 8, **characterised in that** a flat film comprising a plurality of layers in an even-numbered and mirror-symmetrical layer arrangement is produced by coextruding a film tube comprising a plurality of layers out of an annular die, and subsequently blow moulding and blocking the flattened film tube before hardening.

10. Method according to claim 9, **characterised in that**, in the coextrusion within the outer layer, at least one additional layer of polypropylene is extruded with an inorganic filler in a weight fraction of at least 5%.

11. Method for producing a back sheet according to either claim 9 or claim 10, **characterised in that**, in the coextrusion, an innermost layer consisting of a mixture of polypropylene and polyethylene is extruded.

## Revendications

1. Film arrière destiné à des modules solaires qui sont incorporés dans un copolymère EVA (éthylène-acétate de vinyle) transparent, réticulé à une température de plus de 140°, lorsque dans le film arrière vient en appui sur l'EVA et se fixe à celui-ci, le film arrière étant une construction multicouche pourvue de couches de polyoléfine co-extrudées qui sont reliées directement entre elles et dont une couche avant d'épaisseur de couche inférieure à 100 µm est remplie de pigments ou de particules réfléchissantes dans une proportion en poids allant jusqu'à 20 %, les couches comprenant au total ou en mélange du polypropylène non réticulé et les couches situées derrière la couche avant étant remplies au moins en partie d'une charge minérale stabilisante dans une proportion en poids allant jusqu'à 40 % par rapport au poids du film arrière, **caractérisé en ce que** le film arrière est formé à partir d'un tuyau à film soufflé multicouche qui est doublé symétriquement avant durcissement par formage à plat et adhérence de contact et qui a une épaisseur totale de plus de 300 µm.

2. Film arrière selon la revendication 1, **caractérisé en ce que** la charge comprend essentiellement du talc ou d'autres matières minérales résistantes aux acides.

3. Film arrière selon la revendication 2, **caractérisé en ce que** la charge comprend, dans les couches se trouvant derrière la couche avant, une proportion en poids de la couche d'au moins 5 %.

4. Film arrière selon la revendication 1, 2 ou 3, **caractérisé en ce que** les couches sont disposées dans l'ensemble en nombre pair et à symétrique spéculaire.

5. Film arrière selon la revendication 4, **caractérisé en ce que** les deux couches les plus intérieures adjacentes contiennent un mélange de 30 à 60 % de polyéthylène.

6. Film arrière selon la revendication 5, **caractérisé en ce que** les deux couches les plus intérieures ont chacune une épaisseur inférieure à 80 µm.

7. Film arrière selon la revendication 5 ou 6, **caractérisé en ce que** les deux couches les plus intérieures ne contiennent pas de talc.

8. Film arrière selon l'une des revendications 1 à 7, **caractérisé en ce que** la couche avant contient un pourcentage de polyéthylène pouvant atteindre 30 %.

9. Procédé de fabrication d'une film arrière selon l'une des revendications 1 à 8, **caractérisé en ce qu'**un film plat pourvu d'une pluralité de couches disposées selon un agencement de couches en nombre pair et à symétrie spéculaire est généré par co-extrusion d'un tube à film comportant une pluralité de couches à partir d'une matrice annulaire, suivie d'un processus de soufflage et d'adhérence par contact du tube à film aplati avant le durcissement.

10. Procédé selon la revendication 9, **caractérisé en ce qu'**au moins une autre couche de polypropylène comportant une charge minérale dans une proportion en poids d'au moins 5 % est extrudée lors de la co-extrusion à l'intérieur de la couche extérieure,.

11. Procédé de fabrication d'un film arrière selon la revendication 9 ou 10, **caractérisé en ce qu'**une couche la plus intérieure formée d'un mélange de polypropylène et de polyéthylène est extrudée lors de la co-extrusion.
